# EUROPEAN PATENT APPLICATION

(11) **EP 4 610 971 A1**
(43) Date of publication of application: **03.09.2025**
(21) Application number: 25160406.2
(22) Date of filing: 26.02.2025
(51) Int. Cl.: G09G 3/3233, H10D 86/40

(54) **DISPLAY DEVICE**

(30) Priority: 29.02.2024 KR 20240029871
(71) Applicant: LG Display Co., Ltd., Seoul, 07336 (KR)
(72) Inventor: YANG, Jung Yul, 10845 Paju-si (KR); LEE, Jun Ho, 10845 Paju-si (KR)
(74) Representative: Poll, Christopher

(57) **Abstract**

A display device includes a substrate comprising an active area and a non-active area, and a power voltage line and a gate driver disposed in the non-active area of the substrate and adjacent to each other. In the display device, the gate driver includes a first type transistor including a first active layer on the substrate, a first gate insulating film on the first active layer, and a first gate electrode overlapping the first active layer and located on the first gate insulating film, a second type transistor including a second active layer farther from the substrate than the first gate electrode, a second gate insulating film on the second active layer, and a second gate electrode overlapping the second active layer and located on the second gate insulating film, and a first electrode pattern overlapping the first gate electrode and located on the second gate insulating film.

## Description

This application claims the benefit of Korean Patent Application No. 10-2024-0029871, filed on February 29, 2024.

### FIELD OF THE DISCLOSURE

The present disclosure relates to a display device, and more particularly, to a display device that prevents diffusion of hydrogen in the device and improves driving reliability of a transistor by differentiating configurations of a gate driver and a peripheral section.

### BACKGROUND

Various methods and forms have been used for a display device that displays an image on a TV, a monitor, a smartphone a tablet computer, a notebook computer, etc.

The display device includes a plurality of pixels to implement an image and has a transistor to control an operation of each pixel.

The display device includes a driving circuit and a wire connected to the transistor to apply various signals, thereby driving a plurality of pixels.

The transistors in the display device may include different layer structures for various purposes.

The transistor includes a plurality of electrodes and an insulating film, and a hydrogen component contained in the insulating film may affect an active layer. Research has been conducted to solve this problem.

### SUMMARY

Accordingly, the present disclosure is directed to a display device that substantially obviates one or more problems due to limitations and disadvantages of the related art.

A technical challenge of embodiments of the present disclosure is to capture hydrogen from an adjacent insulating film through an electrode pattern and prevent hydrogen from diffusing to an active layer of a neighboring second type transistor by including a first type transistor closer to a substrate and a second type transistor further from the substrate than the first type transistor and including at least one electrode pattern on the first type transistor.

A technical challenge of the display device of the embodiments of the present disclosure is to block hydrogen horizontally transmitted to a second active layer by having a first type transistor including a first active layer of polysilicon together with a second type transistor including a second active layer of an oxide semiconductor, and providing electrode patterns overlapping with a first gate electrode of the first type transistor and located in an upper layer and a lower layer of the second active layer in a region where arrangement density of the second type transistor is greater than arrangement density of the first type transistor.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor.

The display device of the embodiments of the present disclosure may electrically connect electrode patterns provided on a first type transistor to each other to stabilize a potential, prevent hydrogen components from flowing, and improve hydrogen capture effects.

The display device of the embodiments of the present disclosure may prevent hydrogen diffusion in a second type transistor including an oxide semiconductor by an electrode pattern on a first type transistor, thereby preventing a reduction in effective channel length, which is a problem due to hydrogen diffusion. Accordingly, it is possible to prevent a threshold voltage from shifting in a negative direction due to a reduction in effective channel length. In this way, it is possible to minimize a channel length margin of the second type transistor and improve driving stability.

The display device of the embodiments of the present disclosure may further improve reliability of a transistor including an active layer of an oxide semiconductor provided in an active area by further including first and second connection patterns that overlap with power voltage lines surrounding the active area and are electrically connected to each other.

The display device of the embodiments of the present disclosure may form first and second connection patterns, which overlap with electrode patterns and power voltage lines on a first type transistor, on the same layer as that of a light-shielding pattern and a gate electrode of a second type transistor, thereby obtaining device reliability without adding separate materials or processes. That is, it is possible to achieve process optimization. In addition, since there is no additional process, a process that generates harmful gases is not added, thereby enabling reduction of greenhouse gas emissions.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the disclosure, as embodied and broadly described herein, a display device includes a substrate comprising an active area and a non-active area, and a power voltage line and a gate driver disposed in the non-active area of the substrate and adjacent to each other.

In the display device, the gate driver includes a first type transistor including a first active layer on the substrate, a first gate insulating film on the first active layer, and a first gate electrode overlapping the first active layer and located on the first gate insulating film, a second type transistor including a second active layer farther from the substrate than the first gate electrode, a second gate insulating film on the second active layer, and a second gate electrode overlapping the second active layer and located on the second gate insulating film, and a first electrode pattern overlapping the first gate electrode and located on the second gate insulating film.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:
FIG. 1 is a schematic plan view illustrating a display device according to an embodiment of the present disclosure;
FIG. 2 is a circuit diagram illustrating a subpixel of FIG. 1 according to an embodiment of the present disclosure;
FIG. 3 is a circuit diagram illustrating a part of a gate driver (gate-in-panel (GIP)) according to an embodiment of the present disclosure;
FIG. 4 is a cross-sectional view illustrating a storage capacitor and transistors of different layer structures of the display device according to an embodiment of the present disclosure;
FIG. 5 is a plan view illustrating region A of FIG. 1;
FIG. 6 is a cross-sectional view taken along line I-I' of FIG. 5 ;
FIG. 7 is a cross-sectional view taken along line II-II' of FIG. 5;
FIG. 8 is an enlarged view illustrating region B of FIG. 5;
FIG. 9 is a cross-sectional view taken along line III-III' of FIG. 8;
FIG. 10 is a plan view illustrating first and second electrode patterns and first and second connection patterns located in the same layer in region A of FIG. 1; and
FIG. 11 is a cross-sectional view of a display device according to an embodiment of the present disclosure.

### DETAILED DESCRIPTION

Hereinafter, preferred embodiments of the present disclosure will be described with reference to the attached drawings. In the following description of the present disclosure, where the detailed description of the relevant known steps, elements, functions, technologies, and configurations can unnecessarily obscure an important point of the present disclosure, a detailed description of such steps, elements, functions, technologies, and configurations may be omitted. In addition, the names of elements used in the following description are selected in consideration of clarity of description of the specification, and can differ from the names of elements of actual products.

The shapes, sizes, ratios, angles, numbers, and the like, which are illustrated in the drawings to describe various example embodiments of the present disclosure are merely given by way of example. The disclosure is not limited to the illustrations in the drawings. In the present disclosure, where terms such as "including," "having," "comprising," and the like are used, one or more components can be added, unless the term, such as "only," is used. The terminology used herein is to describe particular aspects and is not intended to limit the present disclosure. As used herein, the terms "a" and "an" used to describe an element in the singular form is intended to include a plurality of elements. An element described in the singular form is intended to include a plurality of elements, and vice versa, unless the context clearly indicates otherwise.

In construing a component or numerical value, the component or the numerical value is to be construed as including an error or tolerance range even where no explicit description of such an error or tolerance range is provided.

In describing the various example embodiments of the present disclosure, where the positional relationship between two elements is described using terms, such as "on", "above", "under" and "next to", at least one intervening element can be present between the two elements, unless "immediate(ly)" or "direct(ly)" or "close(ly) is used. It will be understood that when an element or layer is referred to as being "connected to", or "coupled to" another element or layer, it can be directly connected to or coupled to the other element or layer, or one or more intervening elements or layers can be present.

In describing the various example embodiments of the present disclosure, when terms such as "after," "subsequently," "next," and "before," are used to describe the temporal relationship between two events, another event can occur therebetween, unless a more limiting term, such as "just," "immediate(ly)," or "directly" is used.

In describing the various example embodiments of the present disclosure, terms such as "first" and "second" can be used to describe a variety of components. These terms aim to distinguish the same or similar components from one another and do not limit the components. Accordingly, throughout the specification, a "first" component can be the same as a "second" component within the technical concept of the present disclosure, unless specifically mentioned otherwise.

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

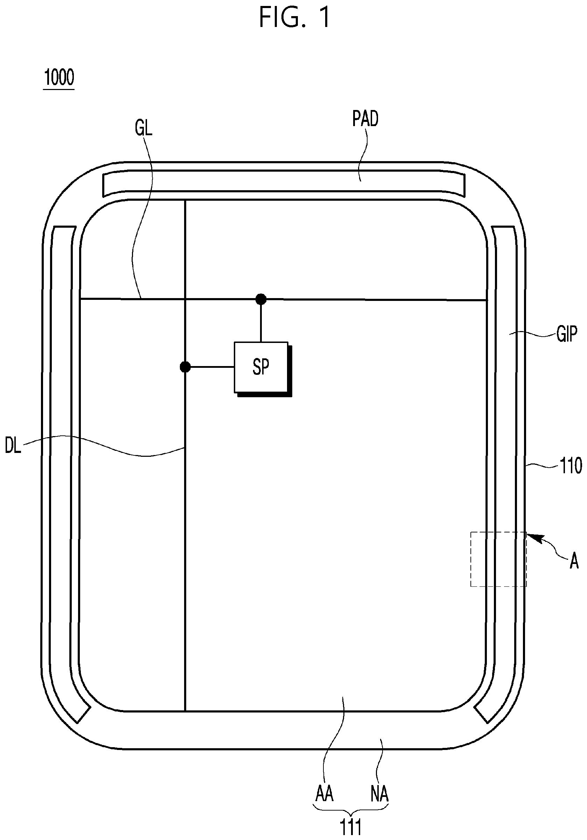

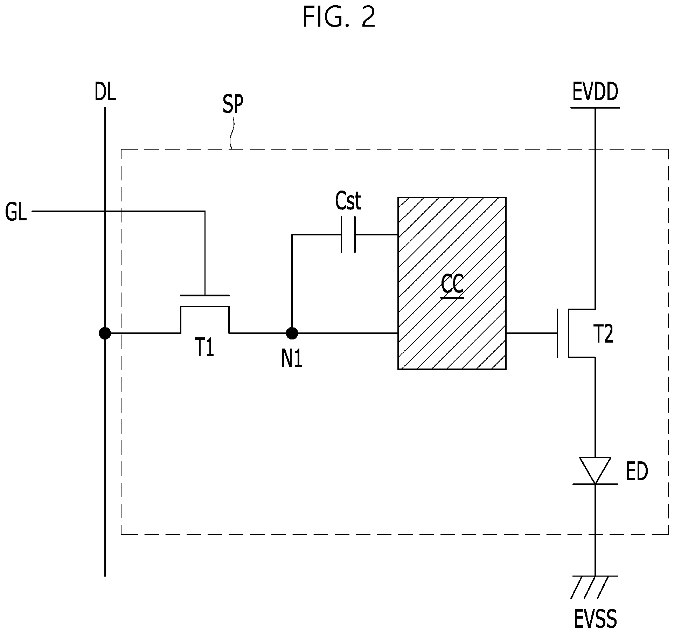

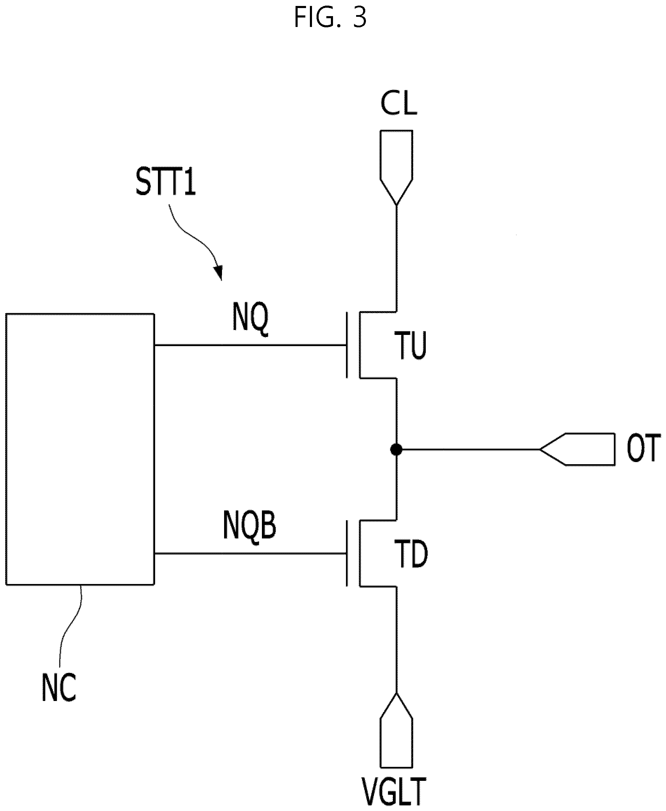

FIG. 1 is a schematic plan view illustrating a display device according to an embodiment of the present disclosure. FIG. 2 is a circuit diagram illustrating a subpixel of FIG. 1 according to an embodiment of the present disclosure. FIG. 3 is a circuit diagram illustrating a part of a gate driver (GIP) according to an embodiment of the present disclosure.

Referring to FIGs. 1 and 2, a display device 1000 according to an embodiment of the present disclosure may include a display panel 110 and a case (not shown) that accommodates a side surface of the display panel 110 and a lower part of the display panel 110. A non-active area NA of the display panel 110 may be hidden by the case or covered by a separate light blocking film. A printed circuit film and/or a battery may be included between the lower part of the display panel 110 and the case.

The display panel 110 may include a substrate 111 including an active area AA and a non-active area NA surrounding the active area AA, and a drive unit connected to the substrate 111. The drive unit may be integrated and formed in the substrate 111 together with a component of an array provided in the active area AA, or may be connected to the substrate 111 using a COG (Chip On Glass) method, or may be connected to a printed circuit board through a film or connector using a COF (Chip On Film) method on the substrate 111. Alternatively, the drive unit may also include a component integrated in the substrate 111 and an external component of a COG or a COF.

The active area AA is an area in which an image is displayed. A plurality of subpixels SP is arranged in the active area AA of the display panel 110, and an image may be displayed using the plurality of subpixels SP. An area other than the active area AA may be a non-active area NA.

The non-active area NA may be arranged in an edge region surrounding the active area AA in which an image is displayed. At least one drive unit for driving the plurality of subpixels SPs may be arranged in the non-active area NA. The drive unit may include a gate driver (GIP) in a GIP form directly formed on the substrate 111. The gate driver (GIP) may be formed in the same process as that of transistors provided in the active area AA. The gate driver (GIP) is connected to a plurality of gate lines GLs in the active area AA and may sequentially supply gate voltage signals to the plurality of gate lines GLs.

A pad PAD including a pad electrode connected to the plurality of gate lines GLs and data lines DLs may be provided on one side of the substrate 111. The pad PAD may be located on a side of the substrate 111. The pad PAD may be disposed between gate drivers GIPs at both sides of the substrate 111.

In the non-active area NA, various additional elements may be further arranged to drive subpixels SPs in the active area AA.

At least one subpixel SP among the plurality of pixels may include a first transistor T1, a second transistor T2, a storage capacitor Cst, a compensation circuit CC, and a light emitting element ED, as shown in FIG. 2.

For example, the first transistor T1 may be a switching transistor, and the second transistor T2 may be a driving transistor.

The first transistor T1 has a first electrode (for example, a drain electrode) electrically connected to a data line DL, and a second electrode (for example, a source electrode) electrically connected to a first node N1. A gate electrode of the first transistor T1 is electrically connected a gate line GL. In response to a scan signal supplied through the gate line GL, the first transistor T1 transmits a data signal supplied through the data line DL to the first node N1.

A storage capacitor Cst is electrically connected to the first node N1 and charged with a voltage applied to the first node N1.

The second transistor T2 has a first electrode (for example, a drain electrode) to which a high-potential driving voltage EVDD is applied, and a second electrode (for example, a source electrode) electrically connected to a first electrode (for example, an anode) of the light emitting element ED. The second transistor T2 may control the amount of driving current flowing to the light emitting element ED according to a voltage difference between the gate electrode and the source electrode.

A semiconductor layer of the first transistor T1 or/and the second transistor T2 may include silicon such as amorphous silicon (a-Si), polysilicon (poly-Si), or low-temperature polysilicon (LTPS), or may include an oxide semiconductor.

The display device of the embodiments of the present disclosure may have advantages of including an oxide semiconductor layer in at least one of the transistors formed on the substrate 111, enabling formation at a relatively low temperature compared to other materials, maintaining amorphous characteristics, having high transmittance characteristics, and adjusting an S-factor to easily express grayscale.

Meanwhile, in the display device of the embodiments of the present disclosure, transistors formed on the substrate 111 include a first type transistor having polysilicon as an active layer and a second type transistor having an oxide semiconductor layer as an active layer, which include a configuration capable of preventing hydrogen diffusion into the second type transistor.

In each subpixel SP, the light emitting element ED outputs light corresponding to a driving current. The light emitting element ED may output light corresponding to any one of red, green, blue, and white.

The light emitting element ED may include the anode, an intermediate layer disposed on the anode, and a cathode supplying a common voltage. The intermediate layer includes at least one light emitting layer, and when an electric field is formed between the anode and the cathode, the intermediate layer may be implemented to emit light of the same color for each pixel, such as white light, or may be implemented to emit different colors for each subpixel SP, such as red, green, or blue light. The intermediate layer may include various types of common layers and functional layers together with the light emitting layer to efficiently supply holes and electrons to the light emitting layer.

The light emitting element ED may be a front emitting diode or a back emitting diode.

The compensation circuit CC may be additionally provided in the subpixel SP to compensate for a threshold voltage, etc., of the second transistor T2. The compensation circuit CC may include one or more transistors. The compensation circuit CC may include one or more transistors and capacitors, and may be configured in various ways depending on the compensation method. A subpixel SP including the compensation circuit CC may include circuits of various structures having different numbers of transistors and/or capacitors, such as 3T1C, 4T2C, 5T2C, 6T1C, 6T2C, 7T1C, and 7T2C.

Among the transistors provided in the subpixel, the switching transistor may require high-speed driving for fast switching operation. The driving transistor may supply high current to the light emitting element and require high current output for high luminance expression.

The gate driver (GIP) included in the non-active area NA outputs gate signals to gate lines according to a gate control signal input from, for example, a timing controller. The gate driver (GIP) may include a plurality of transistors, and the plurality of transistors may be formed in the same process as that of the transistors of the subpixel SP.

For example, the gate driver (GIP) may include stages STT1 that are dependently connected, as shown in FIG. 3, and the stages STT1 may sequentially output gate signals to the gate lines.

As shown in FIG. 3, each of the stages STT1 includes a pull-up node NQ, a pull-down node NQB, a pull-up transistor TU that turns on when the pull-up node NQ is charged with a gate high voltage, a pull-down transistor TD that turns on when the pull-down node NQB is charged with a gate high voltage, and a node controller NC for controlling charging and discharging of the pull-up node NQ and the pull-down node NQB.

The node controller NC may be connected to a start signal line to which a start signal or a carry signal of a previous stage is input, and a clock line to which one of gate clock signals is input. The node controller NC controls charging and discharging of the pull-up node NQ and the pull-down node NQB according to the start signal or the carry signal of the previous stage input to the start signal line and the gate clock signal input to the clock line. To stably control output of the stage STT1, the node controller discharges the pull-down node NQB to the gate low voltage when the pull-up node NQ is charged with the gate high voltage, and discharges the pull-up node NQ to the gate low voltage when the pull-down node NQB is charged to the gate high voltage. To this end, the node controller NC may include a plurality of transistors.

The pull-up transistor TU is turned on when the stage STT1 is pulled up, that is, when the pull-up node NQ is charged with the gate high voltage, and outputs the gate clock signal of the clock line CL to an output terminal OT. The pull-down transistor TD is turned on when the stage STT1 is pulled down, that is, when the pull-down node NQB is charged with the gate high voltage, and discharges the output terminal OT to a gate low voltage of a gate low voltage terminal VGLT.

In FIG. 3, the pull-up transistor TU, the pull-down transistor TD, and the plurality of transistors of the node controller NC of each stage STT1 of the gate driver (GIP) may be transistors having wide channel widths for high response speed and high-voltage output of a high-voltage gate.

Meanwhile, the illustrated example of FIG. 3 is merely an example, the gate driver (GIP) including the stage STT1 includes transistors for various purposes in addition to the two transistors illustrated, and at least the transistors included in the gate driver may include the first type transistor having polysilicon as an active layer and the second type transistor having an oxide semiconductor as an active layer.

In addition, FIG. 2 and FIG. 3 illustrate that the transistors T1 and T2 of the subpixel SP and the pull-up transistor TU, the pull-down transistor TD, and the plurality of transistors of the node controller NC of each stage STT1 of the gate driver (GIP) are formed as N-type semiconductor transistors having N-type semiconductor characteristics. However, embodiments of the present disclosure are not limited thereto. That is, at least one of the pull-up transistor TU, the pull-down transistor TD, and the plurality of transistors of the node controller NC of each stage STT1 of the gate driver (GIP) may be formed as a P-type semiconductor transistor having P-type semiconductor characteristics.

The display panel 110 may include a data drive unit in addition to the gate driver (GIP). For example, the data drive unit may include at least one source drive integrated circuit (hereinafter referred to as "IC"). The source drive IC receives input of digital video data and a source control signal from the timing controller. The source drive IC converts the digital video data into analog data voltages according to the source control signal and supplies the converted analog data voltages to data lines DL.

When the source drive IC is formed as a driving chip such as an integrated circuit, the source drive IC may be mounted on a flexible film using a COF (chip on film) method. Wires connecting pads and the source drive IC, and wires connecting the pads and wires of the circuit board are formed on the flexible film. The flexible film is attached to pads such as data pads formed in the non-display area NA of the display panel DP using an anisotropic conducting film, so that the pads and the wires of the flexible film may be connected.

The circuit of each subpixel SP of the active area of FIG. 2 and the circuit provided in the gate driver (GIP) of FIG. 3 may include transistors having different mobilities for various purposes. For example, a material of the active layer of each transistor may be different to have different mobility. In addition, depending on the material of the active layer, it is possible to form the first type transistor using polysilicon as a first active layer and the second type transistor using an oxide semiconductor as a second active layer.

In some cases, depending on the crystallinity of polysilicon, mobility of the oxide semiconductor may vary depending on the component of metal bonded with oxygen, and a metal content ratio. Accordingly, in the display device according to an embodiment of the present disclosure, the first type transistor and the second type transistor of the same type may include transistors of different structures having different mobilities, respectively.

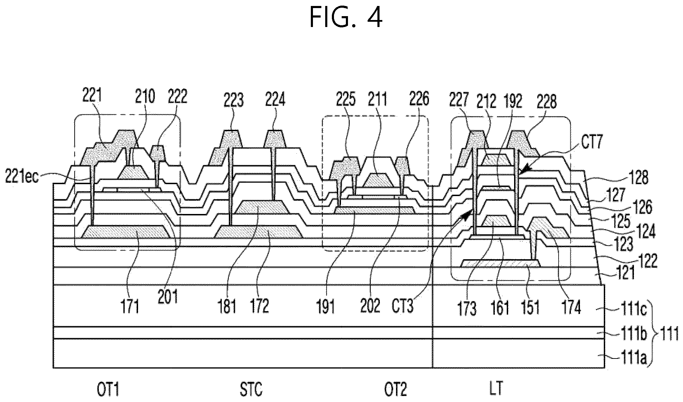

Hereinafter, first, in the display device according to the embodiments of the present disclosure, the gate driver (GIP) or transistors LT, OT1, and OT2 of different layer structures arranged in the gate driver (GIP) and a storage capacitor STC formed in the same process as that of the gate driver (GIP) or transistors will be examined. The first type transistor refers to a transistor using polysilicon as an active layer, and the second type transistor refers to a transistor using an oxide semiconductor as an active layer. The first type transistor refers to LT illustrated in FIG. 4, and the second type transistor may refer to OT1 and OT2 illustrated in FIG. 4.

FIG. 4 is a cross-sectional view illustrating a storage capacitor and transistors of different layer structures of the display device according to an embodiment of the present disclosure.

As shown in FIG. 4, the first type transistor LT includes a first active layer 161 on the substrate 111, a first gate electrode 173 overlapping the first active layer 161 with the first active layer 161 and a third insulating film 123 interposed therebetween, and a first source-drain electrode 227 and a second source-drain electrode 228 connected to opposite sides of the first active layer 161 separated from each other.

Here, the first active layer 161 may be made of polysilicon.

The first type transistor LT including the active layer of polysilicon has high mobility and may be used as a transistor that requires high-speed operation, such as the gate driver (GIP). In the display device according to the embodiments of the present disclosure, the first type transistor LT is not limited to being arranged in the gate driver (GIP). For example, the first type transistor LT may be used in a switching transistor that requires high-speed operation in a driving circuit provided in the subpixel.

The first type transistor LT may further include a first light-shielding pattern 151 on the lower side of the first active layer 161 to prevent photocurrent from being generated or the first active layer 161 from being affected by light entering from the lower side of the substrate 111. The first light-shielding pattern 151 may be connected to a first gate electrode layer 174 connected to the first gate electrode 173 so as to have the same potential as that of the first gate electrode 173. In this case, the first light-shielding pattern 151 may be used as a dual gate together with the first gate electrode 173. The first type transistor LT has an advantage of enabling fast switching operation in a limited area compared to a structure having a single gate electrode since the first gate electrode 173 and the first light-shielding pattern 151 located above and below the first active layer 161 perform a dual switching function. Accordingly, the first type transistor LT may be highly integrated and placed in a subpixel.

The third insulating film 123 functions as a first gate insulating film for the first type transistor LT.

The second type transistor include a first oxide semiconductor transistor OT1 and a second oxide semiconductor transistor OT2 having different structures. The first oxide semiconductor OT1 of the second type transistor may include a second active layer 201, a second gate electrode 210 overlapping the second active layer 201 with the second active layer 201 and a seventh insulating film 127 interposed therebetween, and a third source-drain electrode (not shown) and a fourth source-drain electrode 222 connected to opposite sides of the second active layer 201 separated from each other. The second active layer 201 of the second type transistor OT1 may be located at a position farther away from the first active layer 161 of the first type transistor LT, and a vertical phase of the second type transistor OT1 may be higher than a vertical phase of the first type transistor LT. Therefore, the second active layer 201 of the second type transistor OT1 is formed sequentially after the first active layer 161 and the first gate electrode 173 of the first type transistor LT.

Here, the second active layer 201 may include an oxide semiconductor.

An oxide semiconductor material may include a compound of oxygen and at least one metal among zinc (Zn), indium (In), gallium (Ga), tin (Sn), and titanium (Ti). In some cases, a metal having high conductivity, such as iron (Fe), may be further included in the oxide semiconductor material to increase mobility.

More specifically, examples of the oxide semiconductor material included in the second active layer 201 include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), iron-indium-zinc oxide (FIZO), etc.

The first oxide semiconductor transistor OT1 of the second type transistor may further include a second light-shielding pattern 171 on the lower side of the second active layer 201 to prevent photocurrent from being generated by light entering from the lower side of the substrate 111 and to prevent the second active layer 201 from being affected. The second light-shielding pattern 171 may be connected to the second gate electrode 210 to have the same potential as that of the second gate electrode 210. In this case, the second light-shielding pattern 171 may be used as a dual gate together with the second gate electrode 210. The first type transistor LT has an advantage in that the first gate electrode 173 and the first light-shielding pattern 151 located above and below the first active layer 161 perform a dual switching function, enabling a rapid switching operation in a limited area compared to a structure having a single gate electrode. When the second type transistor OT1 is included in the subpixel SP, the transistor be used as a switching transistor. In this case, even when the second active layer 201 included in the second type transistor OT1 contains an oxide semiconductor, mobility may be further increased by including a material having high conductivity as a metal component or adjusting a content ratio between metals included in the oxide semiconductor.

Here, the seventh insulating film 127 may function as a second gate insulating film for each of the second type transistors OT1 and OT2.

Meanwhile, the display device according to the embodiment of the present disclosure may include the first oxide semiconductor transistor OT1 and the second oxide semiconductor transistor having a different layer structure. The second type transistors OT1 and OT2 include an oxide semiconductor layer as an active layer.

The second oxide semiconductor transistor OT2 of the second type transistor may include a third active layer 202, a third gate electrode 211 overlapping the third active layer 202, the seventh insulating film 127 interposed between the third active layer 202 and the third gate electrode 211, and a fifth source-drain electrode 225 and a sixth source-drain electrode 226 connected to opposite sides of the third active layer 202 separated from each other. The third active layer 202 of the second oxide semiconductor transistor OT2 illustrated in FIG. 4 is positioned in the same layer as that of the second active layer 201 of the first oxide semiconductor transistor OT1, and the third gate electrode 211 is positioned in the same layer as that of the second gate electrode 210, so that at least one layer of the second oxide semiconductor transistor OT2 and the first oxide semiconductor transistor OT1 may be formed in the same process to optimize the process.

However, in the second oxide semiconductor transistor OT2, a third light-shielding pattern 191 for preventing light from entering from the lower side of the substrate 111 is located further from the substrate 111 than the second light-shielding pattern 171 of the first oxide semiconductor transistor OT1, and the third light-shielding pattern 191 overlaps with the third active layer 202 with a sixth insulating film 126 interposed therebetween.

The third light-shielding pattern 191 of the second oxide semiconductor transistor OT2 is connected to an extension of the fifth source-drain electrode 225 that extends farther outward than the third active layer 202, and the same potential as that of the fifth source-drain electrode 225 is applied. Therefore, a potential of the third light-shielding pattern 191 may be stabilized.

Meanwhile, the second oxide semiconductor transistor OT2 is driven by a single gate electrode, as opposed to the dual gate structure of the first oxide semiconductor transistor OT1, and thus may ensure a certain section until the drain current Ids is saturated according to a change in the gate voltage Vgs compared to the first oxide semiconductor transistor OT1. Since gradation expression is possible within a certain section where Vgs of Vgs-lds changes, the second oxide semiconductor transistor OT2 may be used as a driving transistor in a subpixel.

The first and second oxide semiconductor transistors OT1 and OT2 may include a metal having a hydrogen capture function in each of the second gate electrode 210 and the third gate electrode 211 vertically adjacent to the second active layer 201 and the third active layer 203, for example, to prevent hydrogen from being transferred to the second active layer 201 and the third active layer 202. For example, the second gate electrode 210 and the third gate electrode 211 may include titanium (Ti). In order to improve conductivity, the second gate electrode 210 and the third gate electrode 211 may include a triple-stacked structure of titanium (Ti) layer/aluminum (Al) layer/titanium (Ti) layer. In addition, to prevent hydrogen from being transferred to the third active layer 202, the third light-shielding pattern 191 vertically adjacent to the third active layer 203 may be formed of a metal having a hydrogen capture function. The third light-shielding pattern 191 may include titanium.

First and second storage electrodes 172 and 181 included in the storage capacitor STC may be formed together with the electrodes included in the first type transistor LT and the second type transistors OT1 and OT2 provided on the substrate 111. In the illustrated example, a first storage electrode 172 is provided on the same layer and using the same material as those of the first gate electrode 173 of the first type transistor LT. However, the present disclosure is not limited thereto.

Meanwhile, the second type transistors OT1 and OT2 including an oxide semiconductor tend to have a conductive region spread by hydrogen ions. The second type transistors OT1 and OT2 have the second and third active layers 201 and 202, the second and third gate electrodes 210 and 211, and the second and third light-shielding patterns 171 and 191 arranged on several layers. In particular, when hydrogen remains inside the seventh insulating film 127 and the sixth insulating film 126 adjacent to the second and third active layers 201 and 202, a hydrogen component may flow and flow into the active layer of the oxide semiconductor. When the hydrogen ions remaining in the insulating film adjacent to the active layer flow and flow into the active layer of the second type transistors OT1 and OT2, the conductive region of the active layer may spread and an effective channel length may decrease. In addition, when the effective channel length in the transistor decreases, a threshold voltage may shift in a negative direction, so that off-state characteristics of the transistor may become unstable.

For example, the residual hydrogen component in the insulating film may be due to plasma gas used during a conductorizing process of the active layer including the oxide semiconductor layer, residual components of an etchant included during a process of forming a contact hole, etc. remaining in the insulating film.

In the circuit of the subpixel SP, an arrangement area of transistors is not large, hydrogen may be captured to the third active layer 202 by the second and third gate electrodes 210 and 211 and the third light-shielding pattern 191 vertically adjacent to the second active layer 201 and the third active layer 202.

However, a circuit configuration is integrated and densely arranged in the gate driver (GIP), and an arrangement density of the second type transistor OT1 or OT2 that uses an oxide semiconductor layer as the active layer is smaller than an arrangement of the first type transistor LT that uses polysilicon as the active layer. In this case, it may be difficult for a hydrogen flow horizontally transmitted through an insulating film to be sufficiently blocked by the second and third gate electrodes 210 and 211 or the third light-shielding pattern 191 of the second type transistor OT2 or the third type transistor OT3.

The display device according to the embodiments of the present disclosure may further arrange a first electrode pattern 212 and/or a second electrode pattern 192 so as to overlap the first gate electrode 173 in a region of the first type transistor LT that occupies a major area in the gate driver (GIP), thereby capturing hydrogen and preventing horizontal diffusion of hydrogen through the insulating film, so that it is possible to prevent diffusion of hydrogen to the second type transistor OT1 or OT2 adjacent to the first type transistor LT.

The second electrode pattern 192 overlaps the first gate electrode 173 of the first type transistor LT. The second electrode pattern 192 is disposed at a same layer as that of the third light-shielding pattern 191. The third light-shielding pattern 191 is disposed under the sixth insulating film 126. The second electrode pattern 192 and the third light-shielding pattern 191 are located below the second active layer 201 and the third active layer 202. The first electrode pattern 212 overlaps the first gate electrode 173 of the first type transistor LT, and is located in the same layer as that of the second and third gate electrodes 210 and 211 located on the upper side of the seventh insulating film 127 located on the upper side of the second active layer 201 and the third active layer 202. The second and first electrode patterns 192 and 212 contact the sixth insulating film 126 and the seventh insulating film 127 closest to the second active layer 201 and the third active layer 202, so that hydrogen horizontally transmitted through the sixth insulating film 126 and the seventh insulating film 127 may be blocked. A bottom surface of the first electrode pattern 212 may be in contact with the seventh insulating film 127. An upper surface of the second electrode pattern 192 is in contact with the sixth insulating film 126.

Hereinafter, a vertical structure of FIG. 4 will be described in detail.

The substrate 111 may be formed of a flexible plastic material and thus may have flexibility. For example, the substrate 111 may include first and second substrates 111a and 111c made of organic materials and overlapping each other with an inorganic interlayer film 111b interposed therebetween. The first and second substrates 111a and 111c may include different organic films of the same or different types, such as PET (polyethylene terephthalate) and polyimide. In some cases, an adhesive film, such as a PSA (pressure sensitive adhesive) film, may be included as an intermediate layer between the first and second substrates 111a and 111c.

The substrate 111 serves to support and protect components of the display device 1000 arranged on the upper side.

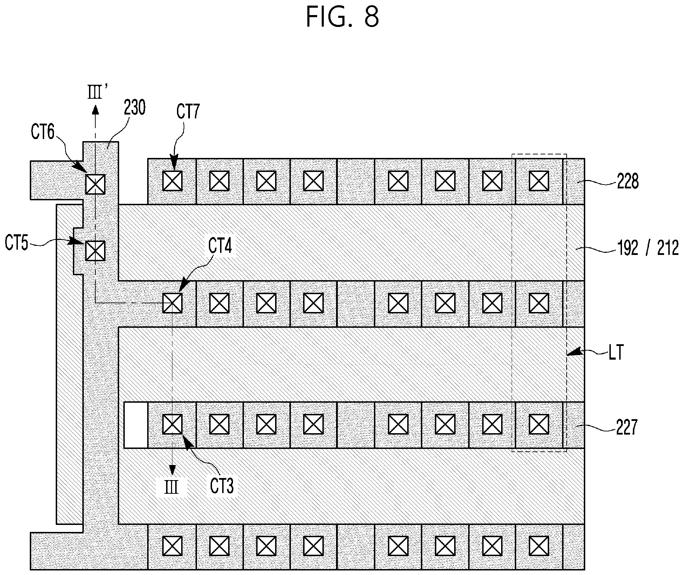

In addition to the first and second transistors T1 and T2 described in FIG. 2, various types of transistors included in the compensation circuit CC may be provided in the active area AA of the substrate 111. FIG. 8 illustrates, as an example, a driving transistor T connected to the light emitting element ED.

A plurality of inorganic insulating films 121, 122, 123, 124, 125, 126, 127, and 128 is arranged in the active area AA and non-active area (see NA of FIG. 1) of the substrate 111 so that electrodes located in different layers included in the first to third type transistors LT, OT1, and OT2 may be insulated from each other.

The inorganic insulating film may include a first insulating film 121, a second insulating film 122, a third insulating film 123, a fourth insulating film 124, a fifth insulating film 125, a sixth insulating film 126, a seventh insulating film 127, and an eighth insulating film 128.

The first insulating film 121 is disposed in the active area AA and the non-active area NA on the substrate 111. The first insulating film 121 may be referred to as a buffer layer and may perform the same function as that of a buffer layer known in the art. The first insulating film 121 may be disposed on the substrate 111 to protect structures located in an upper part of the substrate 111 from moisture penetrating through the substrate 111 and may flatten a surface of the substrate 111.

The first insulating film 121 may be disposed adjacent to an edge of the substrate 111 or disposed up to the edge of the substrate 111 to prevent moisture from penetrating from the edge of the substrate 111. The first insulating film 121 may be a single inorganic film or may include a plurality of inorganic films that are alternately stacked.

For example, the first insulating film 121 may include one or more inorganic films among a silicon oxide (SiOx) film, a silicon nitride (SiNx) film, and a silicon oxynitride (SiOxNy) film, or may include multiple layers in which the inorganic films described above are stacked.

The first light-shielding pattern 151 may be provided on the first insulating film 121 using a conductive metal material. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

A second insulating film 122 may be arranged on the first insulating film 121 including the first light-shielding pattern 151. The second insulating film 122 may function as a buffer layer of the first type transistor LT including polysilicon as an active layer, for example. In this case, the second insulating film 122 is positioned under the polysilicon semiconductor layer and may function as a buffer layer of the polysilicon semiconductor layer. The second insulating film 122 may include an inorganic film, for example, a silicon oxide (SiOx) film, a silicon nitride (SiNx) film, or a multilayer film thereof. The first active layer 161 including polysilicon is provided on the second insulating film 122 so as to overlap with the first light-shielding pattern 151. The first active layer 161 may be formed, for example, by depositing amorphous silicon, then applying heat thereto to perform a crystallization process, and then performing patterning to have a predetermined width at which the first active layer 161 overlaps with the first light-shielding pattern 151.

The third insulating film 123 is arranged on the second insulating film 122 including the first active layer 161. A bottom surface of the first electrode pattern 212 may be in contact with the seventh insulating film 127. An upper surface of the second electrode pattern 192 is in contact with the sixth insulating film 126. The third insulating film 122 may include one or more inorganic films among a silicon oxide (SiOx) film, a silicon nitride (SiNx) film, and a silicon oxynitride (SiOxNy) film.

The third insulating film 123 and the second insulating film 122 may be selectively removed to form a contact hole exposing a portion of an upper part of the first light-shielding pattern 151.

The first gate electrode 173 may be provided using a conductive metal material on the third insulating film 123. The first storage electrode 172 and the second light-shielding pattern 171 of the second type transistor OT1 may be provided in the same layer. Specifically, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

The first gate electrode extension 174 is further provided on the same layer as that of the first gate electrode 173, and the first gate electrode extension 174 may be connected to the first light-shielding pattern 151 through a contact hole provided in the second and third insulating films 122 and 123.

The first light-shielding pattern 151 and the second light-shielding pattern 171 may prevent light coming from the lower side of the substrate 111 from affecting the first active layer 161 and the second active layer 201, thereby solving a problem caused by photocurrent.

The first storage electrode 172 may form one electrode of a capacitor included in a driver of the non-active area or the subpixel.

The fourth insulating film 124 may be arranged on the third insulating film 123 to cover the second light-shielding pattern 171, the first storage electrode 172, and the first gate electrode 173. The fourth insulating film 124 may have an insulating function with the active layer or other electrodes that are subsequently formed.

The fourth insulating film 124 may include an inorganic material. The inorganic material may include, for example, a silicon nitride (SiNx) film.

A second storage electrode 181 may be provided on the fourth insulating film 124 at a position overlapping the first storage electrode 172 using a conductive metal material. The conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

The fifth insulating film 125 is formed of an inorganic insulating material such as a silicon nitride film, a silicon oxide film, or a silicon oxynitride film on the fourth insulating film 124, covering the second storage electrode 181.

As a hydrogen-capturing metal layer on the fifth insulating film 125, the third light-shielding pattern 191 is provided at a position of the second oxide semiconductor transistor OT2 of the second type transistor, and the first electrode pattern 192 is provided at a position overlapping the first gate electrode 173. The hydrogen-capturing metal may include, for example, at least titanium. The hydrogen-capturing metal may be formed of a single metal having a hydrogen-capturing function, or may be formed of an alloy with the hydrogen-capturing metal.

The sixth insulating film 126 is provided on the fifth insulating film 125. The third light-shielding pattern 191 and the first electrode pattern 192 may be disposed on the fifth insulating film 125 and may be covered by the sixth insulating film 126.

The sixth insulating film 126 may function as a buffer layer of the second and third active layers 201 and 202 of the oxide semiconductor. The sixth insulating film 126 may serve to flatten a surface of a region where the first and second active layers 180 disposed thereon are formed.

The sixth insulating film 126 may include an inorganic material. The inorganic material may include, for example, a silicon oxide (SiOx) film or multiple layers in which inorganic films are stacked. The sixth insulating film 126, which is closest to the second and third active layers 201 and 202 of the oxide semiconductor, preferably includes a silicon oxide film having a low hydrogen content.

On the sixth insulating film 126, the second active layer 201 and the third active layer 202 are arranged at positions overlapping the second light-shielding pattern 171 and the third light-shielding pattern 191, respectively. The second and third active layers 201 and 202 include, for example, an oxide semiconductor material. The oxide semiconductor material may be formed by a combination of an oxide and at least one metal among zinc (Zn), indium (In), gallium (Ga), tin (Sn), and titanium (Ti). In some cases, a metal having high conductivity, such as iron (Fe), may be further included in the oxide semiconductor material to increase mobility.

More specifically, examples of the oxide semiconductor material included in the second and third active layers 201 and 202 may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), iron-indium-zinc oxide (FIZO), etc.

The seventh insulating film 127 having an inorganic insulating film component is arranged to cover the second and third active layers 201 and 202. The seventh insulating film 127 is positioned on the second and the third active layers 201 and may function as a gate insulating film of the second type transistor OT1 and OT2. It may be preferable to include a silicon oxide film having a low hydrogen content in the seventh insulating film 126 closest to the second and third active layers 201 and 202 of the oxide semiconductor.

The second gate electrode 210 and the third gate electrode 211 are arranged on the seventh insulating film 127 at positions overlapping the channels of the second active layer 201 and the third active layer 202, respectively. In addition, in the same process, the first electrode pattern 212 is arranged to overlap the first gate electrode 173 and the first electrode pattern 192 in the same layer.

The eighth insulating film 128 having an inorganic insulating film component is provided to cover the second and third gate electrodes 210 and 211 and the first electrode pattern 212.

Then, contact holes CT3 and CT7 are prepared by selectively removing the eighth insulating film 128, the seventh insulating film 127, the sixth insulating film 126, the fifth insulating film 125, the fourth insulating film 124, and the third insulating film 123. In the same process, a contact hole is formed by selectively removing the eighth insulating film 128, the seventh insulating film 127, the sixth insulating film 126, the fifth insulating film 125, and the fourth insulating film 124, thereby exposing a part of an upper surface of the second light-shielding pattern 171 and a part of an upper surface of the first storage electrode 172. In the same process, a contact hole is formed by selectively removing the eighth insulating film 128, the seventh insulating film 127, the sixth insulating film 126, and the fifth insulating film 125, thereby exposing a part of an upper surface of the second storage electrode 181. In the same process, a contact hole is formed by selectively removing the eighth insulating film 128, the seventh insulating film 127, and the sixth insulating film 126, thereby exposing a part of the third light-shielding pattern 191. In the same process, a contact hole is formed by selectively removing the eighth insulating film 128 and the seventh insulating film 127, thereby exposing upper surfaces of both sides of the second active layer 201 and the third active layer 202. In the same process, a contact hole is formed by selectively removing the eighth insulating film 128, thereby exposing a part of an upper surface of the second gate electrode 210.

The contact hole provided in each of the insulating films is filled, a conductive metal material is formed, and the conductive metal material is patterned on the eighth insulating film 128 to form each of source-drain electrodes 222, 225, 226, 227, and 228 and storage connection electrodes 223 and 224.

Upper surfaces on both sides of the first active layer 161 may be exposed by the contact holes CT3 and CT7 and connected to the first and second source-drain electrodes 227 and 228.

Upper surfaces on both sides of the third active layer 202 may be exposed by the contact holes provided in the insulating films 127 and 128 and connected to the fifth and sixth source-drain electrodes 225 and 226.

In addition, the fifth source-drain electrode 225 may be connected to a part of an upper surface of the third light-shielding pattern 191 further protruding from one side of the third active layer 202 and exposed.

Upper surfaces of both sides of the second active layer 201 may be exposed by contact holes provided in the insulating film 127 and 128 and connected by a fourth source-drain electrode 224.

In addition, a part of the upper surface of the second gate electrode 210 and a part of the upper surface of the first light-shielding pattern 171 may be connected to each other by a connection electrode 221 and an extension portion 221ec. The connection electrode 221 is disposed on the eight insulation film 128. The extension portion 221ec is vertically disposed in a contact hole penetrated through the third to eight insulation films 123, 124, 125, 126, 127 and 128. The extension portion 221ec is directly connected to connection electrode 221. The connection electrode 221 may be integral as the extension portion 221ec in the third to eight insulation films 123, 124, 125, 126, 127 and 128.

The first storage connection electrode 223 is connected to the first storage electrode 172 on the lower side, and the second storage connection electrode 224 is connected to the second storage electrode 181 on the lower side.

Hereinafter, configurations of the gate driver and a part around the gate driver will be described in more detail.

Hereinafter, the first type transistor refers to a transistor using polysilicon as an active layer, and the second type transistor refers to a transistor using an oxide semiconductor as an active layer. The first type transistor refers to LT described in FIG. 4, and the second type transistor may refer to OT1 and OT2 described in FIG. 4.

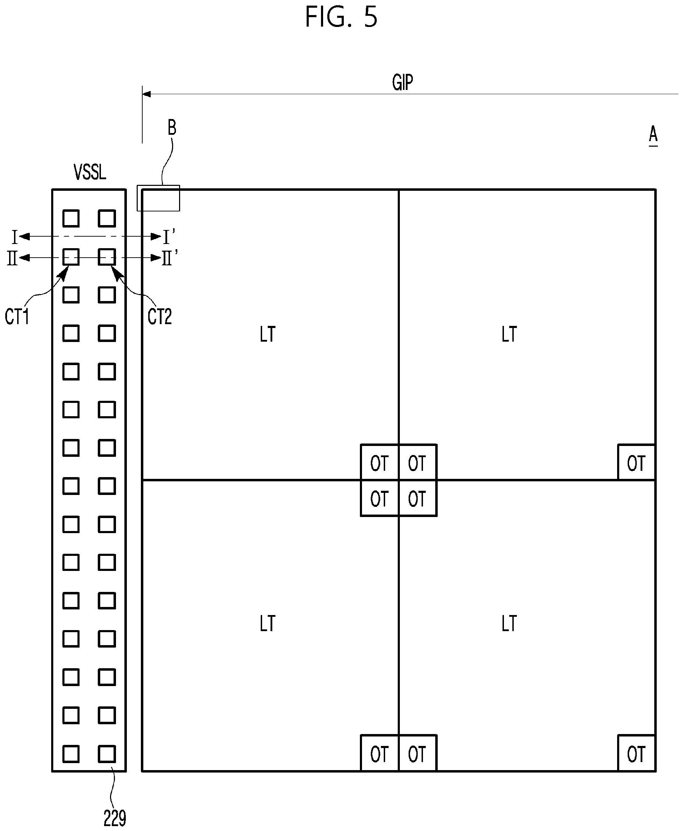

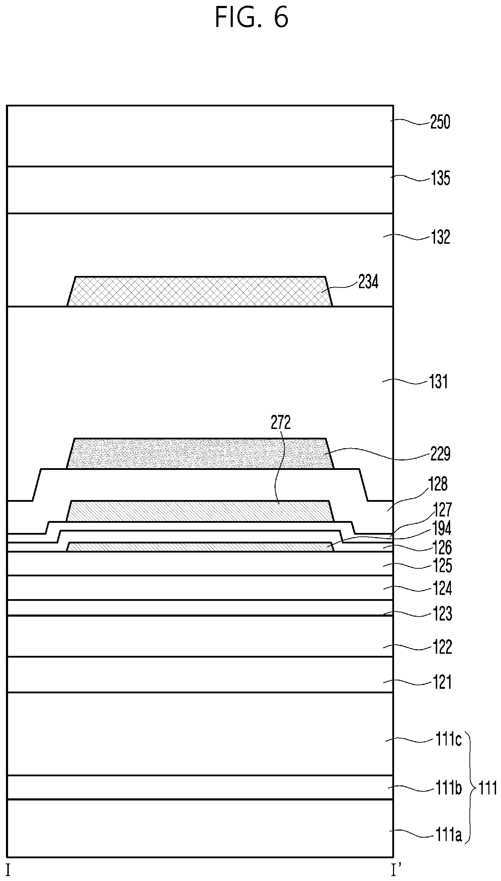

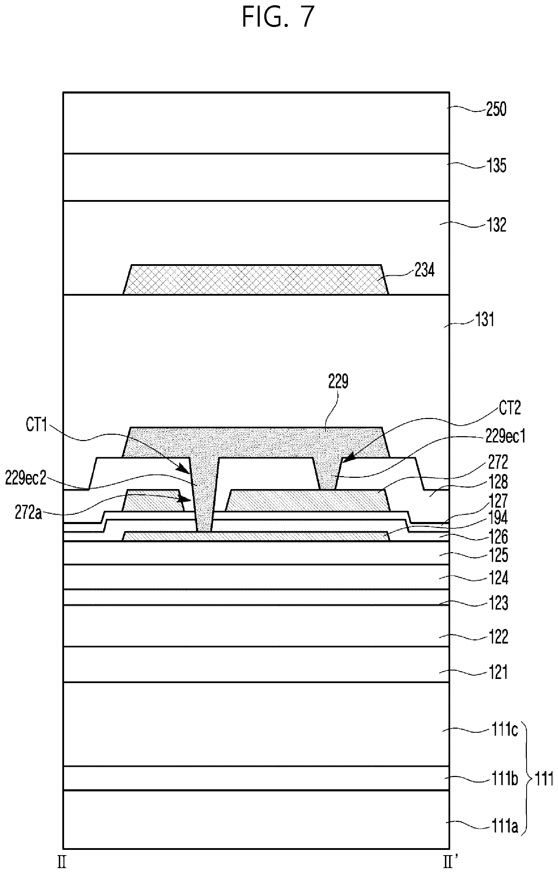

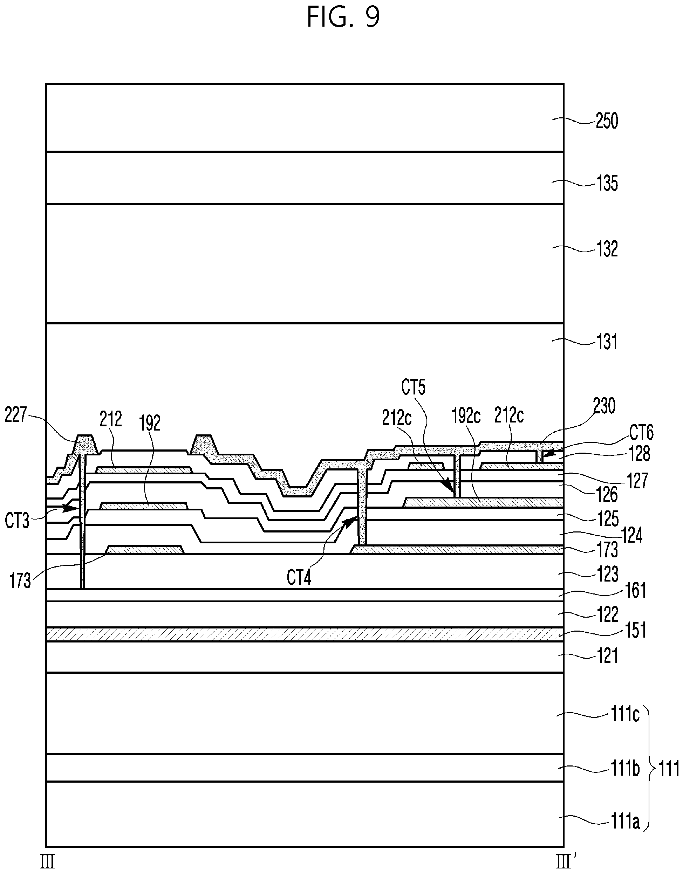

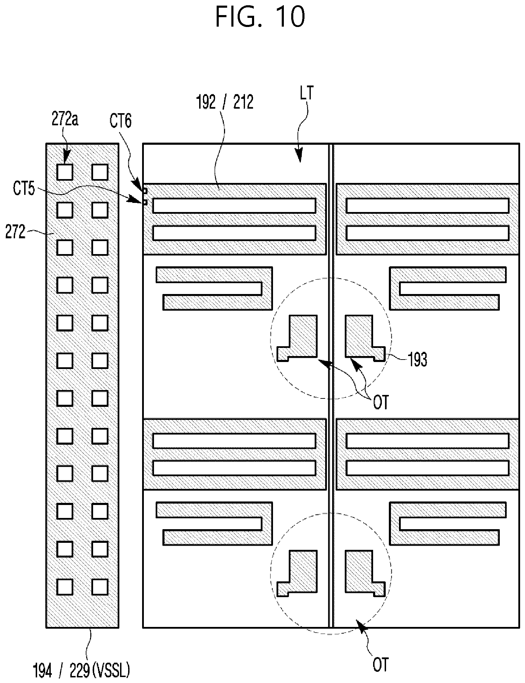

FIG. 5 is a plan view illustrating region A of FIG. 1, and FIG. 6 is a cross-sectional view taken along line I-I' of FIG. 5. FIG. 7 is a cross-sectional view taken along line II-II' of FIG. 5. Also, FIG. 8 is an enlarged view illustrating region B of FIG. 5. FIG. 9 is a cross-sectional view taken along line III-III' of FIG. 8. FIG. 10 is a plan view illustrating first and second electrode patterns and first and second connection patterns located in the same layer in region A of FIG. 1.

As shown in FIG. 1 and FIG. 5, the display device according to an embodiment of the present disclosure may include the substrate 111 including the active area AA and the non-active area NA, and a first power voltage line VSSL and the gate driver (GIP) disposed in the non-active area NA of the substrate 111 and adjacent to each other.

The first power voltage line VSSL supplies a low voltage or a ground voltage VSS to a cathode of the light emitting element ED and may be disposed in a region surrounding the periphery of the active area AA. The first power voltage line VSSL may be disposed between the active area AA and the gate driver (GIP). The first power voltage line VSSL may extend from the active area AA and be connected to the cathode located in the non-active area NA to supply the low voltage or the ground voltage VSS to the cathode.

In the display device according to an embodiment of the present disclosure, the first power voltage line VSSL may be formed as a multilayer structure, as shown in FIG. 5, FIG. 6, and FIG. 7. In addition, metal layers of the multilayer structure include a second connection electrode 194 and a first connection pattern 272 having a hydrogen capture function to prevent hydrogen diffusion to the adjacent second type transistor (OT: OT1 or OT2).

With reference to FIG. 1 and FIG. 2, the active area AA includes subpixels SPs in regions where the plurality of gate lines GL and data lines DL intersect and has the light emitting element ED in each of the subpixels SPs, and the first power voltage line VSSL may be electrically connected to the cathode of the light emitting element ED.

The first power voltage line VSSL includes a source-drain metal layer 239 located in the same layer as that of the source-drain electrodes (222, 225, and 226 of FIG. 4) of the transistors and the storage connection electrode 223 and 224, the second connection pattern 194 located in the same layer as that of the light-shielding pattern 191 located on the lower side of the active layers 201 and 202 including the oxide semiconductor of the second type transistor (OT: OT1 or OT2), and the first connection pattern 272 located in the same layer as that of the gate electrodes 210 and 211 located on the upper side of the active layer 201 and 202 including the oxide semiconductor of the second type transistor (OT: OT1 or OT2).

The light-shielding pattern 191 positioned on the lower side of the active layers 201 and 202 of the second type transistor (OT: OT1 or OT2), and the gate electrodes 210 and 211 positioned on the upper side of the active layers 201 and 202 each include a hydrogen-capturing metal to prevent direct hydrogen diffusion to the active layers 201 and 202 in the second type transistor (OT: OT1 or OT2) in a vertical direction. For example, the light-shielding pattern 191 of the second type transistor OT may include titanium, and the gate electrodes 210 and 211 of the second type transistor OT may include a multilayer structure of titanium layer/aluminum layer/titanium layer. Mobility of the transistor may be increased by including a metal having high conductivity along with the hydrogen capture function of the gate electrodes 210 and 211 of the second type transistor.

The first power voltage line VSSL may include the second connection pattern 194 and the first connection pattern 191. The second connection pattern is disposed at a same layer as that of the light-shielding pattern 191 of the second oxide semiconductor transistor OT2 of the second type transistor OT. The first connection pattern 272 is disposed at a same layer as that of the gate electrodes 210 and 211 of the second oxide semiconductor transistor OT2 of the second type transistor (OT: OT1 or OT2). The second connection pattern 194 may include a same material as that of the light-shielding pattern 191 of the second type transistor OT. The first connection electrode 272 may include a same material as the gate electrodes 210 and 211 of the second type transistor (OT: OT1 or OT2). The material of the light-shielding pattern 191 and the gate electrodes 210 and 211 of the second type transistor OT may include hydrogen-capturing metal, at least one of the first connection electrode 272 and second connection pattern 194 may include hydrogen-capturing metal thereby enhancing the hydrogen capture function around the active area AA. That is, for the transistors of each subpixel of the active area AA and the second type transistor OT included in the gate driver (GIP), the first power voltage line VSSL is a multilayer structure including a hydrogen-capturing metal, and the second and first connecting patterns 194 and 272 may capture hydrogen ions in the adjacent insulating films 125, 126, 127, and 128 and prevent lateral diffusion of hydrogen in the insulating films 125, 126, 127, and 128.

The display device according to the embodiment of the present disclosure further includes the first and second electrode patterns 212 and 192 having a hydrogen capture function in the gate driver (GIP) itself as well as the first and second connection patterns 272 and 194 included in the multilayer structure of the first power voltage line VSSL, as shown in FIG. 10, to capture hydrogen, thereby blocking horizontal movement of hydrogen transmitted to the second type transistor OT and preventing a change in effective channel length due to hydrogen.

In addition, the first power voltage line VSSL may reduce resistance by having electrical connection between wires in the multilayer structure. As shown in FIG. 7, the second connection electrode 194 may be connected to a first source-drain metal layer 229 through a contact hole CT1 in the sixth to eighth insulating films 126, 127, and 128 inside an opening 272a in the first connection pattern 272. In addition, the first connection electrode 272 may be connected to the first source-drain metal layer 229 through a contact hole CT2 in the eighth insulating film 128. Here, the first source-drain metal layer 229 is connected to the first connection pattern 272 through a vertical an extension portion 229ec1 that extend vertically to the contact holes CT2 in the eight insulating film 128 and the first source-drain metal layer 229 is connected to the second connection pattern 194 through extension portions 229ec2 that extend vertically to the contact holes CT1 provided in the sixth to eight insulating films 126, 127 and 128.

Meanwhile, the first power voltage line VSSL may include not only the first source-drain metal layer 229, but also a second source-drain metal layer 234 overlapping the first source-drain metal layer 229, as shown in FIGs. 6 and 7. The second source-drain metal layer 234 may be disposed on a first planarization film 131.

The second source-drain metal layer 234 has an effect of further reducing resistance of the first power voltage line VSSL by being electrically connected to the first source-drain metal layer 229. Further, when the first and second source-drain metal layers 229 and 234 overlap, there is an effect of shielding operation of the light emitting element ED or a touch function part located on the upper side.

The first source-drain metal layer 229 and the second source-drain metal layer 234 are made of a conductive metal material. For example, the conductive metal material may include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti).

An additional planarization film, bank, sealing layer, etc. may be further provided on the second source-drain metal layer 234.

FIG. 6 illustrates a plurality of arrangements of first type transistors LTs included in the gate driver (GIP).

As shown in FIG. 6, the first type transistors LTs are arranged in a first direction (X-axis) in one region of the gate driver (GIP). Each first type transistor LT may share the first and second source-drain electrodes 227 and 228 and a gate connection metal layer 230.

The first and second source-drain electrodes 227 and 228 and the gate connection metal layer 230 may be parallel in the first direction in the arrangement region of the first type transistors LTs.

The first and second source-drain electrodes 227 and 228 may be connected to the first active layer 161 through the contact holes CT3 and CT7 provided in the insulating films 123, 124, 125, 126, 127, and 128, as shown in FIGs. 4 and 9.

As shown in FIGs. 6 and 10, the first and second electrode patterns 192 and 212 having a hydrogen capture function are provided between regions where the first and second source-drain electrodes 227 and 228 are provided, so that arrangement density of the electrodes having a hydrogen capture function in a region of the gate driver (GIP) may be increased.

In the display device according to the embodiments of the present disclosure, the source-drain electrodes 222, 225, 226, 227, and 228, the storage connection electrodes 223 and 224, and the gate connection metal layer 230 of each of the transistors LT and OT may be positioned in the same layer as that of the power voltage line.

As shown in FIG. 10, a gate electrode 193 of the second type transistor OT has a hydrogen capture function, and may be formed using the same material, such as titanium, and in the same process as those of the first electrode pattern 212. Referring FIG. 9 and FIG. 10, the first electrode pattern 212 may include a connection portion 212c at a same layer as the first electrode pattern 212 for receiving an electrical signal. The first electrode pattern 212 and the connection portion 212c may be integral. The second electrode pattern 192 may include a connection portion 192c at a same layer as the second electrode pattern 192 for receiving an electrical signal. The second electrode pattern 192 and the connection portion 192c may be integral. A same gate voltage signal may be applied into the first electrode pattern 212, the second electrode pattern 192 and the first type gate electrode 173.

In addition, the second electrode pattern 192 may be formed in the same process as that of the light-shielding pattern 191 of the second type transistor OT.

Therefore, when forming the first and second electrode patterns 212 and 192 provided in the gate driver (GIP), the process may be optimized by forming the electrode patterns together with transistors in a formation process of the transistors without adding a separate metal, and it is possible to prevent emission of harmful gases such as greenhouse gases.

In the gate driver (GIP), the first type transistors LTs are arranged to surround the second type transistor OT, and the first and second electrode patterns 212 and192 provided to overlap the horizontally adjacent second type transistor OT capture hydrogen and prevent hydrogen diffusion to the second type transistor LT.

The first and second electrode patterns 192 and 212 may be arranged to overlap the first type gate electrode 173.

In addition, the gate connection metal layer 230 is provided in the same layer as that of the first and second source-drain electrodes 227 and 228, extends in a direction intersecting the first direction on one side, and may be connected to the first gate electrode 173, the second electrode pattern 192, and the first electrode pattern 212 by contact holes CT4, CT5, and CT6 provided in the insulating films 124, 125, 126, 127, and 128 in a region not overlapping with the first and second source-drain electrodes 227 and 228.

Specifically, the gate connection metal layer 230 is connected to the first gate electrode 173 through the contact hole CT4 provided in the insulating films 124, 125, 126, 127, and 128. As shown in FIG. 9, a part of the first gate electrode 173 connected to the gate connection metal layer 230 may protrude more to one side than each of connection portions 212c and 129c of the first and second electrode patterns 212 and 192.

The gate connection metal layer 230 is connected to a connection portion 192c of the second electrode pattern 192 exposed from the first electrode pattern 212 through the contact hole CT5 provided in the insulating films 126, 127, and 128. As shown in FIG. 9, the connection portion 212c of the first electrode pattern 212 may have an opening in the contact hole CT5 where the connection portion 192c of the second electrode pattern 192 and the gate connection metal layer 230 are connected to each other.

The gate connection metal layer 230 is connected to a connection portion 212c of the first electrode pattern 212 through the contact hole CT6 provided in the eighth insulating film 128. As shown in FIG. 9, the connection portion 212c of the first electrode pattern 212 connected to the gate connection metal layer 230 may be connected by providing the contact hole CT6 in a different region from that of the contact hole CT5 which is a connection region between the connection portion 192c of the second electrode pattern 192 and the gate connection metal layer 230.

The gate connection metal layer 230 may be provided in the same layer as that of the first and second source-drain electrodes 227 and 228.

Meanwhile, the gate driver (GIP) may cover the first type transistor LT and may be further protected by providing a first planarization film 131, a second planarization film 132, a bank 235, and a sealing layer 250.

As shown in FIG. 5 and FIG. 10, in the display device according to the embodiment of the present disclosure, arrangement density of the first type transistor LT in the gate driver (GIP) may be higher than that of the second type transistor OT.

For convenience of the process, the first type transistor LT and the second type transistor OT of the same type may be formed close to each other.

In addition, as shown in FIG. 5, the gate driver (GIP) requires many transistors that require high operation speed, so that arrangement density of the first type transistor LT having relatively higher mobility may be higher than that of the second type transistor OT having relatively lower mobility.

The first and second electrode patterns 212 and 192 having hydrogen capture characteristics may be included in the first type transistor LT located around the second type transistor OT including the oxide semiconductor having low arrangement density, so as to block lateral diffusion of hydrogen. In particular, the first and second electrode patterns 212 and 192 are provided adjacent to an upper part and a lower part of the active layer (see 201 and 202 of FIG. 4) of the second type transistor OT, and the second and first electrode patterns 192 and 212 directly in contact with the insulating films 126 and 127, which may mainly introduce hydrogen into the active layer 201 and 202 of the second type transistor OT, may have a hydrogen capture function to effectively block hydrogen diffusion. Accordingly, it is possible to improve operational reliability of the second type transistor including the oxide semiconductor.

A technical challenge of the display device of the embodiments of the present disclosure is to capture hydrogen from an adjacent insulating film through an electrode pattern and prevent hydrogen from diffusing to the active layer of the neighboring second type transistor by including a first type transistor closer to the substrate and a second type transistor further from a substrate than the first type transistor and including at least one electrode pattern on the first type transistor.

A technical challenge of the display device of the embodiments of the present disclosure is to block hydrogen horizontally transmitted to a second active layer by having a first type transistor including a first active layer of polysilicon together with a second type transistor including the second active layer of an oxide semiconductor, and providing electrode patterns overlapping with a first gate electrode of the first type transistor and located in an upper layer and a lower layer of the second active layer in a region where arrangement density of the second type transistor is greater than arrangement density of the first type transistor.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor, prevent shift of a threshold voltage of the second type transistor, minimize a channel length margin of the second type transistor, and improve driving stability.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor.

The display device of the embodiments of the present disclosure may electrically connect electrode patterns provided on a first type transistor to each other to stabilize a potential, prevent hydrogen components from flowing, improve hydrogen capture effects, and as a result, ensure operational reliability of several transistors.

The display device of the embodiments of the present disclosure may prevent hydrogen diffusion in a second type transistor including an oxide semiconductor by an electrode pattern on a first type transistor, thereby preventing a reduction in effective channel length, which is a problem due to hydrogen diffusion. Accordingly, it is possible to prevent a threshold voltage from shifting in a negative direction due to a reduction in effective channel length. In this way, it is possible to minimize a channel length margin of the second type transistor and improve driving stability.

The display device of the embodiments of the present disclosure may further improve reliability of a transistor including an active layer of an oxide semiconductor provided in an active area by further including first and second connection patterns that overlap with power voltage lines surrounding the active area and are electrically connected to each other.

The display device of the embodiments of the present disclosure further includes first and second connection patterns that overlap with a power voltage line surrounding an active area and are electrically connected to each other, thereby reducing resistance of power voltage lines using a multi-wiring structure.

The display device of the embodiments of the present disclosure may form first and second connection patterns, which overlap with electrode patterns and power voltage lines on a first type transistor, on the same layer as that of a light-shielding pattern and a gate electrode of a second type transistor, thereby obtaining device reliability without adding separate materials or processes. That is, the display device of the embodiments of the present disclosure may achieve process optimization. In addition, since there is no additional process, a process that generates harmful gases is not added, thereby enabling reduction of greenhouse gas emissions.

In addition, the display device of the embodiments of the present disclosure may reduce resistance in a power voltage line, thereby achieving high efficiency using the same power consumption, and minimize an increase in material costs and have sustainable effects, thereby advantageously being ecofriendly. Accordingly, ESG (Environmental/Social/Governance) goals may be implemented.

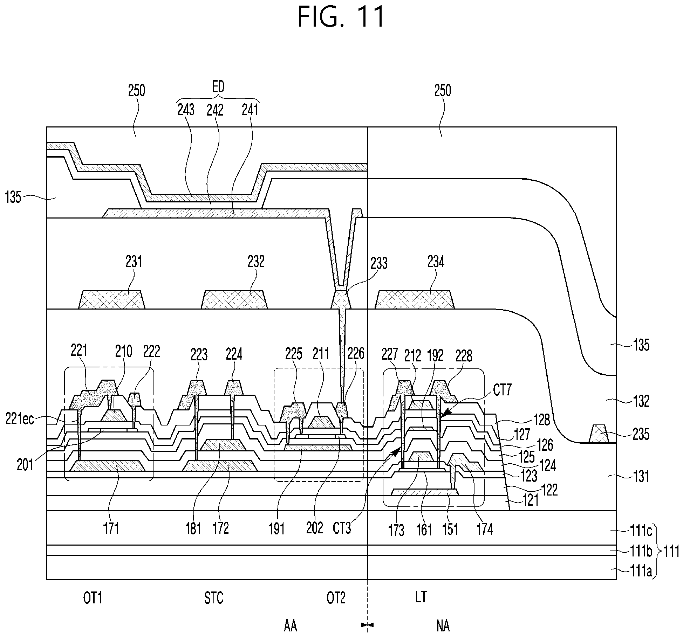

FIG. 11 is a cross-sectional view of a display device according to an embodiment of the present disclosure.

Description of the same configuration as that described in FIG. 4 is omitted.

A first planarization film 131 may be provided to cover the first type transistor LT using polysilicon as the active layer 161, the second type transistors OT1 and OT2 using an oxide semiconductor as the active layers 201 and 202, and the storage capacitor STC.

The second type transistors OT1 and OT2 having different connection structures from those of the light-shielding patterns 171 and 191 may function as a switching transistor and a driving transistor, respectively.

In addition, although not shown, the first type transistor LT and the second type transistor OT using an oxide semiconductor as an active layer may be further included in the non-active area NA. The second source-drain metal layer 234 in the first power voltage line VSSL may be arranged to overlap the first type transistor LT. The first power voltage line VSSL may be applied so that driving of the first type transistor LT may function to shield a configuration arranged above the light emitting element ED. The first power voltage line VSSL may be provided in a shape surrounding the active area AA in the non-active area NA with a certain width, and may overlap with the first type transistor LT provided in the gate-in panel GIP at part of the width or the entire width.

The first power voltage line VSSL to which a low-voltage driving signal is applied may include the first and second connection patterns (272 and 194 of FIGs. 6 and 7) that partially overlap and have a connection structure, and be provided in the non-active area NA together with the first source-drain metal layer (229 of FIGs. 6 and) in the same layer as that of the source-drain electrodes 222, 225, 226, 227, and 228 of the transistors.

On the first planarization film 131, second source-drain metal layers 231, 232, and 223 are arranged using a conductive metal material to prevent a lower configuration of the first oxide semiconductor transistor OT1 and the storage capacitor STC from being affected by driving of an upper configuration.

Meanwhile, an anode connection electrode 233 is provided to be connected to one source-drain electrode 226 of the second oxide semiconductor transistor OT2 that functions as a driving transistor in the second source-drain metal layer, so that the light emitting element ED located on the upper side may be connected to an anode 241.

The second planarization film 132 is arranged on the second source-drain metal layers 231, 232, and 233.

The first and second planarization films 131 and 132 may include an organic material. The organic material may include one or more of an acrylic resin, a phenolic resin, a polyimide resin, an unsaturated polyester resin, a polyamide resin, benzocyclobutene, a polyphenylene resin, and a polyphenylene sulfide resin.

In addition, the second planarization film 132 is provided with a contact hole exposing the anode connection electrode 233, and may be connected to one source-drain electrode 226 of the transistor OT2 functioning as a driving transistor through the anode 241 and the anode connection electrode 233 that are subsequently arranged.

One of the anode 241 and the cathode 243 of the light emitting element ED may include a reflective electrode, and the other may include a transparent electrode or a reflective-transparent electrode.

When the anode 241 includes a reflective electrode, the anode 241 may function to shield light from being incident on the first and second transistors T1 and T2 of the lower part. The anode 241 may be formed of, for example, a stacked structure of a first transparent electrode, a reflective electrode, and a second transparent electrode. The second transparent electrode, which is an uppermost electrode of the anode 241, may lower a barrier for hole injection at an interface with the intermediate layer EL as a dielectric. Here, the first and second transparent electrodes may be transparent oxide electrodes such as ITO and IZO. The reflective electrode may include silver, a silver alloy such as APC (Ag-Pd-Cu), aluminum, or an aluminum alloy.

For example, the anode 241 may be formed of a multilayer structure such as a stacked structure (Ti/Al/Ti) of aluminum (Al) and titanium (Ti), a stacked structure (ITO/AI/ITO) of aluminum (Al) and ITO, an APC (Ag/Pd/Cu) alloy, a stacked structure (ITO/APC/ITO) of an APC alloy and ITO, and a stacked structure (Ag/MoTI) of silver (Ag) and an molybdenum/titanium alloy, or may include a single layer structure made of one material selected from silver (Ag), aluminum (Al), molybdenum (Mo), gold (Au), magnesium (Mg), calcium (Ca), or barium (Ba), or an alloy of two or more thereof.

A bank 135 is arranged to surround an edge of the anode 241, and the bank 135 extends to the non-active area NA, functions as a bank pattern 225A in a bending area BA and a periphery thereof, and may protect a lower link pattern 235 in the bending area BA and the periphery thereof.

The bank 135 exposing a light emitting portion of the anode 241 may be arranged in each of the subpixels SPs.

The bank 135 may include an inorganic material or an organic material. The bank 135 may include an opaque material (for example, black) to prevent optical interference between adjacent subpixels SP. In this case, the bank 135 may include a light-shielding material made of at least one of a color pigment, organic black, and carbon.

An intermediate layer 242 may include a hole injection layer, a hole transport layer, a light emitting layer, an electron transport layer, an electron injection layer, etc. The intermediate layer 242 may be formed by configuring a plurality of stacks including the hole transport layer, the light emitting layer, and the electron transport layer, and may be formed in a tandem structure including a charge generation layer between the stacks. The charge generation layer may include, for example, an n-type charge generation layer and a p-type charge generation layer.

The light emitting layer included in the intermediate layer 242 may be provided differently for each subpixel. The light emitting layer EL may include a red light emitting layer that emits red light, a green light emitting layer that emits green light, and a blue light emitting layer that emits blue light. The red light emitting layer, the green light emitting layer, and the blue light emitting layer may be arranged for each subpixel SP on the anode 241.

For example, a red light emitting layer may be patterned and arranged for a red subpixel, a green light emitting layer may be patterned and arranged for a green subpixel, and a blue light emitting layer may be patterned and arranged for a blue subpixel. The present disclosure is not necessarily limited thereto, and at least two or more organic light emitting layers among the red light emitting layer, the green light emitting layer, and the blue light emitting layer may be stacked and arranged for one subpixel SP.

The light emitting layer EL may be a white light emitting layer that emits white light. In this case, the light emitting layer EL may be in the form of a common layer in which one or more layers are commonly arranged in the subpixels SPs rather than in a patterned form.

As described above, a light emitting layer 342 may be arranged in a tandem structure of two or more stacks STACK. In this instance, each light emitting element ED may include a charge generation layer arranged between the stacks. The charge generation layer may be a common layer arranged on the entire surface of the active area AA.

The cathode 243 may be formed by thinning a transparent electrode such as ITO or IZO, or a reflective transparent electrode such as silver, a silver alloy, magnesium, a magnesium alloy, ytterbium (Yb), or an ytterbium alloy. In another embodiment, in order to increase transmittance in a transmission portion TA, the cathode 243 may be partially removed from a region of the transmission portion TA or formed with a thin thickness. The cathode 243 may be a common layer commonly arranged across the subpixels SP and applies the same voltage. To this end, the cathode 243 may be arranged to extend from the active area AA to a part of the non-active area NA.

The cathode 243 may be a light-transmitting electrode. The cathode 243 may include a transparent conductive material (TCO) such as ITO or IZO that may transmit light, or a semi-transmissive conductive material such as magnesium (Mg), silver (Ag), or an alloy of magnesium (Mg) and silver (Ag). When the cathode 243 is formed of a semi-transmissive conductive material, light emitting efficiency may be increased by a micro cavity.

In the above description, a front emitting type light emitting element ED has been described as an example. However, the light emitting element ED of the present disclosure is not limited thereto, and may be a back emitting type light emitting element ED in which light emitted from the intermediate layer 242 is emitted toward the substrate 111. In this case, the anode 241 may include a transparent or translucent electrode material, and the cathode 243 may include a reflective electrode material.

A sealing layer 250 is arranged on the light emitting element ED. The sealing layer 250 may cover the active area AA and the non-active area NA to prevent oxygen or moisture from penetrating into the light emitting element ED. Other layers, such as a capping layer, may be interposed between the sealing layer 250 and the cathode 243 as needed.

The sealing layer 250 may include a plurality of layers. The sealing layer 250 may be formed to have a structure in which an inorganic film including an inorganic insulating material and an organic film including an organic insulating material are alternately stacked. For example, the inorganic insulating material may include one or more materials among silicon oxide, silicon nitride, and/or silicon oxynitride.

The organic insulating material may include one or more materials selected from the group consisting of polyethylene terephthalate, polyethylene naphthalate, polycarbonate, polyimide, polyethylene sulfonate, polyoxymethylene, polyarylate, and hexamethyldisiloxane.

A capping layer (not shown) may be further formed on the cathode 243 to protect the cathode 243 of the light emitting element ED and increase upward light emission efficiency.

The display device according to the embodiments of the present disclosure may improve stability and reliability of a transistor provided in the display device by increasing arrangement density of a metal layer having a hydrogen capture function around a transistor including an oxide semiconductor, thereby capturing hydrogen components flowing into the oxide semiconductor layer from the surroundings.

A technical challenge of embodiments of the present disclosure is to capture hydrogen from an adjacent insulating film through an electrode pattern and prevent hydrogen from diffusing to an active layer of a neighboring second type transistor by including a first type transistor closer to a substrate and a second type transistor further from the substrate than the first type transistor and including at least one electrode pattern on the first type transistor.

A technical challenge of the display device of the embodiments of the present disclosure is to block hydrogen horizontally transmitted to a second active layer by having a first type transistor including a first active layer of polysilicon together with a second type transistor including a second active layer of an oxide semiconductor, and providing electrode patterns overlapping with a first gate electrode of the first type transistor and located in an upper layer and a lower layer of the second active layer in a region where arrangement density of the second type transistor is greater than arrangement density of the first type transistor.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor, prevent shift of a threshold voltage of the second type transistor, minimize a channel length margin of the second type transistor, and improve driving stability.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor.

The display device of the embodiments of the present disclosure may electrically connect electrode patterns provided on a first type transistor to each other to stabilize a potential, prevent hydrogen components from flowing, improve hydrogen capture effects, and as a result, ensure operational reliability of several transistors.

The display device of the embodiments of the present disclosure may prevent hydrogen diffusion in a second type transistor including an oxide semiconductor by an electrode pattern on a first type transistor, thereby preventing a reduction in effective channel length, which is a problem due to hydrogen diffusion. Accordingly, it is possible to prevent a threshold voltage from shifting in a negative direction due to a reduction in effective channel length. In this way, it is possible to minimize a channel length margin of the second type transistor and improve driving stability.

The display device of the embodiments of the present disclosure may further improve reliability of a transistor including an active layer of an oxide semiconductor provided in an active area by further including first and second connection patterns that overlap with power voltage lines surrounding the active area and are electrically connected to each other.

The display device of the embodiments of the present disclosure further includes first and second connection patterns that overlap with a power voltage line surrounding an active area and are electrically connected to each other, thereby reducing resistance of power voltage lines using a multi-wiring structure.

The display device of the embodiments of the present disclosure may form first and second connection patterns, which overlap with electrode patterns and power voltage lines on a first type transistor, on the same layer as that of a light-shielding pattern and a gate electrode of a second type transistor, thereby obtaining device reliability without adding separate materials or processes. That is, the display device of the embodiments of the present disclosure may achieve process optimization. In addition, since there is no additional process, a process that generates harmful gases is not added, thereby enabling reduction of greenhouse gas emissions.

In addition, the display device of the embodiments of the present disclosure may reduce resistance in a power voltage line, thereby achieving high efficiency using the same power consumption, and minimize an increase in material costs and have sustainable effects, thereby advantageously being ecofriendly. Accordingly, ESG (Environmental/Social/Governance) goals may be implemented.

A technical challenge of the display device of the embodiments of the present disclosure is to capture hydrogen from an adjacent insulating film through an electrode pattern and prevent hydrogen from diffusing to the active layer of the neighboring second type transistor by including a first type transistor closer to the substrate and a second type transistor further from a substrate than the first type transistor and including at least one electrode pattern on the first type transistor.

A technical challenge of the display device of the embodiments of the present disclosure is to block hydrogen horizontally transmitted to a second active layer by having a first type transistor including a first active layer of polysilicon together with a second type transistor including the second active layer of an oxide semiconductor, and providing electrode patterns overlapping with a first gate electrode of the first type transistor and located in an upper layer and a lower layer of the second active layer in a region where arrangement density of the second type transistor is greater than arrangement density of the first type transistor.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor, prevent shift of a threshold voltage of the second type transistor, minimize a channel length margin of the second type transistor, and improve driving stability.

In the display device of the embodiments of the present disclosure, to prevent an active layer of a second type transistor, among a first type transistor and the second type transistor which are heterogeneous and provided in a gate driver of a substrate, from becoming conductive, electrode patterns, which are each located in the same layer as that of a gate electrode and a light-shielding pattern of the second type transistor, are sequentially arranged on top of a gate electrode of the first type transistor to capture hydrogen between the first type transistor and the second type transistor, so that it is possible to prevent diffusion of hydrogen horizontally transmitted from the first type transistor to the second type transistor.

The display device of the embodiments of the present disclosure may electrically connect electrode patterns provided on a first type transistor to each other to stabilize a potential, prevent hydrogen components from flowing, improve hydrogen capture effects, and as a result, ensure operational reliability of several transistors.

The display device of the embodiments of the present disclosure may prevent hydrogen diffusion in a second type transistor including an oxide semiconductor by an electrode pattern on a first type transistor, thereby preventing a reduction in effective channel length, which is a problem due to hydrogen diffusion. Accordingly, it is possible to prevent a threshold voltage from shifting in a negative direction due to a reduction in effective channel length. In this way, it is possible to minimize a channel length margin of the second type transistor and improve driving stability.

The display device of the embodiments of the present disclosure may further improve reliability of a transistor including an active layer of an oxide semiconductor provided in an active area by further including first and second connection patterns that overlap with power voltage lines surrounding the active area and are electrically connected to each other.

The display device of the embodiments of the present disclosure further includes first and second connection patterns that overlap with a power voltage line surrounding an active area and are electrically connected to each other, thereby reducing resistance of power voltage lines using a multi-wiring structure.

The display device of the embodiments of the present disclosure may form first and second connection patterns, which overlap with electrode patterns and power voltage lines on a first type transistor, on the same layer as that of a light-shielding pattern and a gate electrode of a second type transistor, thereby obtaining device reliability without adding separate materials or processes. That is, the display device of the embodiments of the present disclosure may achieve process optimization. In addition, since there is no additional process, a process that generates harmful gases is not added, thereby enabling reduction of greenhouse gas emissions.

In addition, the display device of the embodiments of the present disclosure may reduce resistance in a power voltage line, thereby achieving high efficiency using the same power consumption, and minimize an increase in material costs and have sustainable effects, thereby advantageously being ecofriendly. Accordingly, ESG (Environmental/Social/Governance) goals may be implemented.

A display device according to one embodiment of the present disclosure may comprise a substrate comprising an active area and a non-active area and a power voltage line and a gate driver disposed at the non-active area of the substrate and adjacent to each other. The gate driver may comprise a first type transistor including a first active layer on the substrate, a first gate insulating film on the first active layer, and a first gate electrode overlapping the first active layer and located on the first gate insulating film, a second type transistor including a second active layer farther from the substrate than the first gate electrode, a second gate insulating film on the second active layer, and a second gate electrode overlapping the second active layer and located on the second gate insulating film, and a first electrode pattern overlapping the first gate electrode and located on the second gate insulating film.

A display device according to one embodiment of the present disclosure may further comprise a second electrode pattern overlapping the first gate electrode with a first interlayer insulating film, which is most adjacent to the second active layer, interposed therebetween. At least the first interlayer insulating film and another interlayer insulating film are arranged between the second active layer and the first gate electrode.

In a display device according to one embodiment of the present disclosure, the first electrode pattern and the second electrode pattern may comprise a hydrogen-capturing metal.

In a display device according to one embodiment of the present disclosure, the first electrode pattern may comprise a metal located at a same layer as a layer of the second gate electrode.

In a display device according to one embodiment of the present disclosure, the first electrode pattern may comprise a stacked layer of a first titanium layer, an aluminum layer, and a second titanium layer.

A display device according to one embodiment of the present disclosure may further comprise a first light-shielding pattern arranged below the first active layer while overlapping the first active layer and a second light-shielding pattern arranged below the first interlayer insulating film while overlapping the second active layer. The second electrode pattern may be located at a same layer as a layer of the second light-shielding pattern.

In a display device according to one embodiment of the present disclosure, the first light-shielding pattern may have a same potential as a potential of the first gate electrode.

In a display device according to one embodiment of the present disclosure, the second light-shielding pattern may have a same potential as a potential of a source-drain region of the second active layer.

In a display device according to one embodiment of the present disclosure, the first electrode pattern and the second electrode pattern may be electrically connected to each other.

In a display device according to one embodiment of the present disclosure, the first electrode pattern may be electrically connected to the first gate electrode.

In a display device according to one embodiment of the present disclosure, the first active layer may comprise a polysilicon semiconductor, and the second active layer comprises an oxide semiconductor.

In a display device according to one embodiment of the present disclosure, an arrangement density of the first type transistor may be greater than an arrangement density of the second type transistor in the gate driver.

In a display device according to one embodiment of the present disclosure, the second type transistor may be surrounded by the first type transistor in the gate driver.

In a display device according to one embodiment of the present disclosure, the active area may comprise a plurality of subpixels, and each of the plurality of subpixels may include a third type transistor having an active layer including an oxide semiconductor.

In a display device according to one embodiment of the present disclosure, the first type transistor may comprise a first source-drain electrode and a second source-drain electrode separated from each other and connected to the first active layer, the second type transistor may comprise a third source-drain electrode and a fourth source-drain electrode separated from each other and connected to the second active layer, and the first to fourth source-drain electrodes may be located at a same layer as a layer of the power voltage line.

A display device according to one embodiment of the present disclosure may further comprise a first connection pattern arranged to overlap the power voltage line with at least one insulating film interposed between the power voltage line and the first connection pattern, and a second connection pattern arranged to overlap the power voltage line with the second gate insulating film and at least one interlayer insulating film interposed between the first connection pattern and the second connection pattern.

In a display device according to one embodiment of the present disclosure, the power voltage line may be connected to the first connection pattern through a first connection portion in the at least one insulating film, and the power voltage line may be connected to the second connection pattern through a second connection portion in the at least one insulating film, the second gate insulating film, and the at least one interlayer insulating film.

In a display device according to one embodiment of the present disclosure, each of the first connection pattern and the second connection pattern may comprise a hydrogen-capturing metal.

A display device according to one embodiment of the present disclosure may comprise a substrate comprising an active area and a non-active area, a plurality of gate lines and a plurality of data lines at the active area and intersecting each other; and a gate driver arranged at the non-active area of the substrate and connected to the plurality of gate lines. The gate driver may comprise a first type transistor including a first active layer on the substrate, a first gate insulating film on the first active layer, and a first gate electrode overlapping the first active layer and located on the first gate insulating film, a second type transistor including a second active layer farther from the substrate than the first gate electrode, a second gate insulating film on the second active layer, and a second gate electrode overlapping the second active layer and located on the second gate insulating film, a first electrode pattern overlapping the first gate electrode and located on the second gate insulating film, a first interlayer insulating film between the second active layer and the first gate electrode; and a second electrode pattern overlapping the first gate electrode with the first interlayer insulating film interposed therebetween.

A display device according to one embodiment of the present disclosure may further comprise a power voltage line adjacent to the gate driver and surrounding the active area in the non-active area.

In a display device according to one embodiment of the present disclosure, the active area includes subpixels at regions where the plurality of gate lines and data lines intersect and has a light emitting element at each of the subpixels, and the power voltage line is electrically connected to a cathode of the light emitting element.

A display device according to one embodiment of the present disclosure, may further comprise a first connection pattern arranged to overlap the power voltage line with at least one insulating film interposed between the power voltage line and the first connection pattern, and a second connection pattern arranged to overlap the power voltage line with the second gate insulating film and the first interlayer insulating film interposed between the first connection pattern and the second connection pattern.

In a display device according to one embodiment of the present disclosure, the power voltage line may be connected to the first connection pattern through a first connection portion provided in the at least one insulating film, and the power voltage line may be connected to the second connection pattern through a second connection portion provided in the at least one insulating film, the second gate insulating film, and the first interlayer insulating film.

In a display device according to one embodiment of the present disclosure, each of the first connection pattern and the second connection pattern may comprise a hydrogen-capturing metal.

In a display device according to one embodiment of the present disclosure, each of the first electrode pattern and the second electrode pattern may comprise a hydrogen-capturing metal.

In a display device according to one embodiment of the present disclosure, the first electrode pattern may comprise a metal located at a same layer as a layer of the second gate electrode.

A display device according to one embodiment of the present disclosure may further comprise a first light-shielding pattern below the first active layer while overlapping the first active layer, and a second light-shielding pattern below the first interlayer insulating film while overlapping the second active layer. The second electrode pattern may be located at a same layer as a layer of the second light-shielding pattern.

In a display device according to one embodiment of the present disclosure, the first electrode pattern and the second electrode pattern may be electrically connected to each other.

In a display device according to one embodiment of the present disclosure, the first active layer may comprise a polysilicon semiconductor, and the second active layer may comprise an oxide semiconductor.

A display device according to one embodiment of the present disclosure may further comprise a third type transistor including a third active layer located at a same layer as a layer of the second active layer at the active area.

A display device according to one embodiment of the present disclosure may comprise a gate driver including a first type transistor including a first active layer of polysilicon, a first gate insulating film on the first active layer, a first electrode pattern comprises a hydrogen-capturing metal overlapping first gate and located on the first gate insulating film, and a first gate electrode on the first gate insulating film, a second type transistor including a second active layer second active layer of an oxide semiconductor, a second gate insulating film on the second active layer.

A display device according to one embodiment of the present disclosure may further comprise a second electrode pattern above the first electrode pattern with the second gate insulating film interposed therebetween.

In a display device according to one embodiment of the present disclosure, the first electrode pattern and the second electrode pattern may be electrically connected to each other.

It will be apparent to those skilled in the art that various modifications and variations can be made in the present disclosure without departing from the spirit or scope of the disclosure. Thus, it is intended that the present disclosure cover the modifications and variations of this disclosure provided they come within the scope of the appended claims and their equivalents.

## Claims

1. A display device comprising:
a substrate comprising an active area and a non-active area; and
a power voltage line and a gate driver disposed at the non-active area of the substrate and adjacent to each other,
wherein the gate driver comprises:
a first type transistor including a first active layer on the substrate, a first gate insulating film on the first active layer, and a first gate electrode overlapping the first active layer and located on the first gate insulating film,
a second type transistor including a second active layer farther from the substrate than the first gate electrode, a second gate insulating film on the second active layer, and a second gate electrode overlapping the second active layer and located on the second gate insulating film, and
a first electrode pattern overlapping the first gate electrode and located on the second gate insulating film.

2. The display device according to claim 1, further comprising a second electrode pattern overlapping the first gate electrode with a first interlayer insulating film, which is most adjacent to the second active layer, interposed therebetween,
wherein at least the first interlayer insulating film and another interlayer insulating film are arranged between the second active layer and the first gate electrode.

3. The display device according to claim 2, wherein the first electrode pattern and the second electrode pattern comprise a hydrogen-capturing metal.

4. The display device according to any preceding claim, wherein the first electrode pattern comprises a metal located at a same layer as a layer of the second gate electrode.

5. The display device according to any preceding claim, wherein the first electrode pattern comprises a stacked layer of a first titanium layer, an aluminum layer, and a second titanium layer.

6. The display device according to claim 2 or claim 3, or any one of claims 4 and 5 when depending on claim 2, further comprising:
a first light-shielding pattern arranged below the first active layer while overlapping the first active layer; and
a second light-shielding pattern arranged below the first interlayer insulating film while overlapping the second active layer,
wherein the second electrode pattern is located at a same layer as a layer of the second light-shielding pattern.

7. The display device according to claim 6, wherein the first light-shielding pattern has a same potential as a potential of the first gate electrode; and/or
wherein the second light-shielding pattern has a same potential as a potential of a source-drain region of the second active layer.

8. The display device according to any one of claims 2, 3, 6 and 7, or any one of claims 4 and 5 when depending on claim 2, wherein the first electrode pattern and the second electrode pattern are electrically connected to each other.

9. The display device according to any preceding claim, wherein the first electrode pattern is electrically connected to the first gate electrode.

10. The display device according to any preceding claim, wherein:
the first active layer comprises a polysilicon semiconductor, and
the second active layer comprises an oxide semiconductor.

11. The display device according to any preceding claim, wherein an arrangement density of the first type transistor is greater than an arrangement density of the second type transistor in the gate driver; and/or
wherein the second type transistor is surrounded by the first type transistor in the gate driver.

12. The display device according to any preceding claim, wherein:
the active area comprises a plurality of subpixels, and
each of the plurality of subpixels includes a third type transistor having an active layer including an oxide semiconductor.

13. The display device according to any preceding claim, wherein:
the first type transistor comprises a first source-drain electrode and a second source-drain electrode separated from each other and connected to the first active layer,
the second type transistor comprises a third source-drain electrode and a fourth source-drain electrode separated from each other and connected to the second active layer, and
the first to fourth source-drain electrodes are located at a same layer as a layer of the power voltage line.

14. The display device according to any preceding claim, further comprising a first connection pattern and a second connection pattern arranged to overlap the power voltage line with at least one insulating film, respectively, interposed between the power voltage line and the first connection pattern, and a second connection pattern arranged to overlap the power voltage line with the second gate insulating film and at least one interlayer insulating film interposed between the first connection pattern and the second connection pattern; and optionally:
wherein the power voltage line is connected to the first connection pattern through a first connection portion in the at least one insulating film, and the power voltage line is connected to the second connection pattern through a second connection portion in the at least one insulating film, the second gate insulating film, and the at least one interlayer insulating film.

15. The display device according to claim 14, wherein each of the first connection pattern and the second connection pattern comprises a hydrogen-capturing metal.
